# EUROPEAN PATENT APPLICATION

(11) **EP 4 701 143 A1**
(43) Date of publication of application: **25.02.2026**
(21) Application number: 24195778.6
(22) Date of filing: 22.08.2024
(51) Int. Cl.: H04L 25/03, G01R 31/317, G01R 31/319, H04B 17/00, H04B 17/15, H04B 17/23

(54) **COMPUTER IMPLEMENTED METHOD, MEASUREMENT APPLICATION DEVICE CONTROLLER, AND MEASUREMENT APPLICATION DEVICE**

(71) Applicant: Rohde & Schwarz GmbH & Co. KG, 81671 München (DE)
(72) Inventor: JEDDA, Hela, 85757 Karlsfeld (DE); LEYH, Julian, Nakanoku, 1640014 (JP); GARCIA GOMEZ, Francisco Javier, 81379 München (DE)
(74) Representative: Kehl, Ascherl, Liebhoff & Ettmayr Patentanwälte Partnerschaft mbB

(57) **Abstract**

The present disclosure provides a computer implemented method for analyzing a recorded analog waveform that represents a plurality of symbols, each symbol being represented by the analog waveform in a respective unit interval. The method comprises applying for the recorded analog waveform for each one of the unit intervals a first decision feedback equalizer with correctly processed unit intervals, applying for the recorded analog waveform for each one of the unit intervals at least one second decision feedback equalizer with an error in the processed unit intervals, generating an individual eye diagram for the output of each one of the first decision feedback equalizer and the at least one second decision feedback equalizer, determining a symbol error probability distribution for each one of the generated eye diagrams, and superimposing the generated eye diagrams based on the determined symbol error probability distribution. The disclosure further provides a respective measurement application device controller, and a respective measurement application device.

## Description

### TECHNICAL FIELD

The disclosure relates to a computer implemented method, a measurement application device controller, and a measurement application device.

### BACKGROUND

Although applicable to any type of measurement application, the present disclosure will mainly be described in conjunction with oscilloscopes and eye-diagrams.

When analyzing high-speed serial data communication links, usually so called eye-diagrams are used to assess the quality of the communication link. Respective oscilloscopes may generate the eye-diagrams for the user. Such oscilloscopes increasingly use Decision Feedback Equalizers (DFEs) to mitigate inter-symbol-interference caused for example by the channel. While eye-diagrams are a crucial tool for signal integrity analysis, current solutions for generating eye-diagrams have a limited accuracy.

Accordingly, there is a need for improving eye-diagram generation.

### SUMMARY

The above stated problem is solved by the features of the independent claims. It is understood, that independent claims of a claim category may be formed in analogy to the dependent claims of another claim category.

Accordingly, it is provided:
A computer implemented method for analyzing a recorded analog waveform that represents a plurality of symbols, each symbol being represented by the analog waveform in a respective unit interval. The method comprises applying for the recorded analog waveform for each one of the unit intervals a first decision feedback equalizer with correctly processed unit intervals, applying for the recorded analog waveform for each one of the unit intervals at least one second decision feedback equalizer with an error in the processed unit intervals, generating an individual eye diagram for the output of each one of the first decision feedback equalizer and the at least one second decision feedback equalizer, determining a symbol error probability distribution for each one of the generated eye diagrams, and superimposing the generated eye diagrams based on the determined symbol error probability distribution.

Further, it is provided:
A measurement application device controller for analyzing a recorded analog waveform that represents a plurality of symbols, each symbol being represented by the analog waveform in a respective unit interval. The measurement application device controller comprises a data interface configured to receive the recorded analog waveform, a first decision feedback equalizer coupled to the data interface and configured to equalize each one of the unit intervals based on correctly decoded unit intervals, at least one second decision feedback equalizer coupled to the data interface and configured to equalize each one of the unit intervals based on erroneously decoded unit intervals, an eye diagram creator coupled to the first decision feedback equalizer and the at least one second decision feedback equalizer, wherein the eye diagram creator is configured to generate an individual eye diagram for the output of each one of the first decision feedback equalizer and the at least one second decision feedback equalizer, a probability determiner coupled to the eye diagram creator and configured to determine a symbol error probability distribution for each one of the generated eye diagrams, and an adder coupled to the eye diagram creator and the probability determiner, wherein the adder is configured to superimpose the generated eye diagrams based on the determined symbol error probability distribution.

Further, it is provided:
A measurement application device comprising a measurement application device controller according to the present disclosure, and a measurement interface coupled to the measurement application device controller, wherein the measurement interface is configured to measure an analog waveform and provide the measured analog waveform as digital data to the measurement application device controller.

The present disclosure is based on the finding that the decision feedback equalizer, DFE, processing applied for eye-diagram generation results in a reduced accuracy, because the DFE processing is applied only at one sampling point within each unit interval, UI. In such solutions, the eye-diagram after DFE application represents the histogram assuming correct symbol decoding, usually in the center of the unit interval. In such implementations, possibly wrong symbol decoding is simply ignored.

The known approaches are optimistic, since they assume that the symbol decoding is computed correctly. The derived bit error rate, BER, can differ from the exact BER. In addition, if the sampling point, at which the BER is computed, moves further from the center of the UI, the difference between the computed BER and the exact BER increases.

The present disclosure, therefore, provides the method and the measurement application device, that take into account that a symbol may be erroneously decoded and may then be used e.g., in a feedback loop of the decision feedback equalizer, and for generating an eye diagram.

Consequently, the solution of the present disclosure does not provide a single eye diagram per UI. Instead, the solution of the present disclosure superimposes or overlays multiple eye diagrams per unit interval for generating the final eye diagram.

An analog waveform, e.g., used in a serial bus communication, may represent a plurality of symbols. The analog waveform may to this end comprise so called unit intervals or Uls, wherein each UI represents a specific section or time slot of the analog waveform. Every UI usually represents exactly one symbol.

An exemplary analog waveform may, e.g., comprise two symbols +1, -1, which may each be represented by a specific voltage level.

According to the present disclosure, the analog waveform is recorded, and decision feedback equalizers are applied multiple times to the recorded waveform. A decision feedback equalizer is an element, module or function that uses past symbol values in a feedback filter loop that are applied to the incoming signal of the current symbol or UI as offset. Consequently, if a slicer in a decision feedback equalizer correctly determines the symbol value, the correct offset will be applied. However, if the slicer incorrectly determines the symbol value, an incorrect offset will be applied.

Generally, the decision feedback equalizers in the present disclosure are described as "equalizing", wherein in the context of generating eye diagrams, "equalizing" may especially refer to determining the symbol in a respective UI.

The number of past symbols or Uls that is used in the feedback loop may also be called taps. A 1-tap decision feedback equalizer, consequently, uses one past decoded symbol or UI, i.e., the last or latest processed or decoded symbol or UI. In contrast, a 2-tap decision feedback equalizer uses two previously decoded symbols or Uls in the feedback loop.

The first decision feedback equalizer that is applied to the Uls of the recorded waveform is applied under the assumption of correctly decoded preceding Uls or symbols. The at least one second decision feedback equalizer is, in contrast, applied with at least one incorrectly decoded past symbol or UI.

The first decision feedback equalizer and the at least one second decision feedback equalizer may be the same equalizer, while for the second decision feedback equalizer errors in the decoding of the symbols or Uls are simulated or assumed.

In embodiments, the first decision feedback equalizer and the at least one second decision feedback equalizer may be implemented by the same function or element, and may be used with different parameters sequentially or in parallel. When implemented as software or computer program, a single function my implement the first decision feedback equalizer and the at least one second decision feedback equalizer. Such a function may be called multiple times with the respective parameters.

The output of the first decision feedback equalizer will, consequently, represent the correctly decoded UI that will result in a correct offset being applied to the recorded waveform. In contrast, the output of the at least one second decision feedback equalizer will be based on an intentionally added error regarding the decoding of at least one symbol or UI, and will result in an incorrect offset being applied to the recorded waveform.

An exemplary system may use a PAM-3 signal with signal levels -1, 0, 1, and a 1-tap decision feedback equalizer. In such a system, one previous symbol or UI is provided to the feedback loop, and processed with the currently received symbol or UI. In such an embodiment, both symbols may be identified correctly, or any one or both of the symbols may be incorrectly determined. This results in 9 possible variants, each with a specific symbol error probability distribution. This will be explained in more detail below referring to the figures.

In embodiments, the second decision feedback equalizer may be applied for all combinations or permutations of incorrectly decoded symbols or Uls.

An individual eye diagram is then generated for each one of the outputs of the first decision feedback equalizer and the at least one second decision feedback equalizer.

Generating the individual eye diagrams may refer e.g., to determining an offset for the respective sections of the waveform, i.e. Uls, and moving the waveform of the respective Uls in the vertical axis of the eye diagram according to the determined offset. In a final eye diagram multiple of such generated individual eye diagrams may then be superimpose or overlaid over each other.

In order to provide a final eye diagram, a symbol error probability distribution is determined for these single eye diagrams. The final eye diagram is then generated by superimposing or overlaying the single generated eye diagrams based on the symbol error probability distribution.

Superimposing or overlaying refers to combining the data points of the single eye diagrams, wherein an intensity for each data point is determined by the probability resulting for the respective data point from the symbol error probability distribution. Data points that have a higher probability of occurring will consequently comprise a higher intensity in the final, superimposed eye diagram.

It is understood, that single steps of the claimed method may be performed by respective elements of the measurement application device or any other adequate device. Especially, steps comprising data processing may be performed by a processing element that executes program instructions that, when executed, cause the processing element to perform the respective function. Of course, steps like acquiring or recording data may be performed with the help of a respective data interface, and steps of outputting or displaying data may be performed with a respective data output interface, or a respective display.

A measurement application device according to the present disclosure may comprise any device that may be used in a measurement application to acquire an input signal or to generate an output signal, or to perform additional or supporting functions in a measurement application. A measurement application device may also comprise or be implemented as program application or program applications, also called measurement program application or measurement program applications, that may be executed on a computer device and that may communicate with other measurement application devices in order to perform a measurement task. A measurement application, also called measurement setup, may e.g., comprise at least one or multiple different measurement application devices for performing electric, magnetic, or electromagnetic measurements, especially on single devices under test. A measurement application device according to the present disclosure may be configured to perform such electric, magnetic, or electromagnetic measurements e.g., in a measurement laboratory or in a production facility in the respective production line on a device under test, DUT. An exemplary measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test, or at least one signal generation section for generating electric, magnetic, or electromagnetic signals that may be provided to the device under test. Such a signal acquisition section may comprise, but is not limited to, a front-end for acquiring, filtering, and attenuating or amplifying electrical signals. The signal generation section may comprise, but is not limited to, respective signal generators, amplifiers, and filters. In embodiments, the signal acquisition is performed via the signal acquisition section in a wired or contact-based manner or fashion. To this end, a respective measurement probe may be coupled to the measurement application device via a respective cable. In embodiments, the signal generation and emission is performed via the signal generation section in a wired or contact-based manner or fashion. To this end, a respective signal output probe may be coupled to the measurement application device via a respective cable, or the signal may be output directly via the cable e.g., to a device under test.

Further, when acquiring signals, measurement application devices may comprise a signal processing section that may process the acquired signals. Processing may comprise converting the acquired signals from analog to digital signals, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a spectrum analyzer, or a vector network analyzer. Such a measurement application device may also comprise a signal generation device e.g., a signal generator, especially an arbitrary signal generator, also called arbitrary waveform generator, or a vector signal generator. Further possible measurement application devices comprise devices like calibration standards, or measurement probe tips.

Of course, at least some of the possible functions, like signal acquisition and signal generation, may be combined in a single measurement application device.

In embodiments, the measurement application device may comprise pure data acquisition devices that are capable of acquiring an input signal and of providing the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

The measurement application device controller may comprise or may be provided in or as part of at least one of a dedicated processing element e.g., a processing unit, a microcontroller, a field programmable gate array, FPGA, a complex programmable logic device, CPLD, an application specific integrated circuit, ASIC, or the like. A respective program or configuration may be provided to implement the required functionality. The measurement application device controller may at least in part also be provided as a non-transitory computer program product comprising computer readable instructions that may be executed by a processing element. In a further embodiment, the measurement application device controller may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them. The same applies to any other element, unit or function disclosed herein as part of the the measurement application device, and the method, like the first decision feedback equalizer, the at least one second decision feedback equalizer, the eye diagram creator, the probability determiner, the symbol error probability distribution function, and the adder.

In addition, it is understood, that any required supporting or additional hardware may be provided like e.g., a power supply circuitry and clock generation circuitry.

Generally, any computer program or computer program product disclosed herein is to be understood as a non-transitory computer program product.

The eye-diagram generation approach disclosed in the present disclosure, in contrast to known methods is more exact, since it considers assumptions of correct and wrong symbol decoding. The resulting eye diagram gives the user a realistic insight about the BER at different sampling points within the full UI.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to independent claim 1 can be combined in all variations with each other and the disclosure of the description is not limited to the claim dependencies as specified in the claim set. Further, the features of the dependent claims referring to independent claim 1 may be combined with any of the features of the other independent claims or the dependent claims relating to any one of the other independent claims. In a respective method, respective method steps may perform the function of the respective apparatus elements, and in a respective apparatus, respective apparatus elements may perform the respective method steps.

In an embodiment, which can be combined with all other embodiments mentioned above or below, the superimposing may comprise determining a weight for each data point of the generated eye diagrams based on the symbol error probability distribution, and adding the weighted data points to a final eye diagram.

As already explained above, instead of generating a single eye diagram that assumes correct decoding or identification of all symbols in all Uls of the analog waveform, at least one additional eye diagram is generated based on the second decision feedback equalizer, wherein an erroneous decoding of at least one symbol is assumed for the second decision feedback equalizer.

Such an erroneously processed or decoded UI or symbol will result in the at least one second decision feedback equalizer being provided with a wrong symbol value in the feedback loop.

In modern measurement application systems, the eye diagrams are usually represented by single data points that may be represented as digital data values. These digital data values may e.g., comprise a coordinate of the respective data point and a respective value or intensity of the respective data point.

The value or intensity of the respective data point according to the present disclosure may be determined by the weight that is awarded to each one of the data points by the symbol error probability distribution.

In embodiments, the weight for each data point of the generated eye diagrams may already be determined based on the symbol error probability distribution during the generation of the single eye diagrams.

In another embodiment, which can be combined with all other embodiments mentioned above or below, the symbol error probability distribution may represent the probability of a data point of an eye diagram being output by the first decision feedback equalizer when provided with the recorded analog waveform, e.g., with a UI of the recorded waveform.

The symbol error probability distribution is a function that may determine for a data point within a single eye diagram the probability that the specific data point results as output of the decision feedback equalizer, e.g., the first decision feedback equalizer.

The symbol error probability distribution results from the understanding that usually the probability of correctly decoding a symbol within a UI is largest in the center of the UI, while becoming lower towards the edges of the UI. Consequently, the probabilities or weights of the data points of an eye diagram in or near the center of a UI will be highest for the eye diagram that is generated based on the output of the first decision feedback equalizer. At the same time, the probabilities or weights of the data points of an eye diagram in or near the center of a UI will be lowest for an eye diagram that is generated based on the output of the at least one second decision feedback equalizer. The sum of all probabilities or weights for a respective point in time in the respective III may be near 1 or exactly 1.

Each data point may also be denominated a sample that is sampled at a respective sampling point of a UI, and may comprise a respective distance from the center of the respective UI. The probability or weight is mainly defined by this distance of the respective data point or sample from the center of the III.

It is understood, that the recorded analog waveform may be provided as a respective set of samples or that an analog waveform may be recorded and sampled accordingly.

In an embodiment, which can be combined with all other embodiments mentioned above or below, the symbol error probability distribution may comprise probabilities, which may also be called weights, that are determined based on sampling points in the respective unit intervals, and a predetermined error pattern for the error in the decoded unit intervals.

Each data point may also be denominated a sampling point or sample. Usually, the farther away a sampling point is from the ideal point for sampling and determining the symbol value, e.g., in the center of the UI, the higher the error rate in determining the respective symbol value will be. This means, that the position, time-wise, of the respective sampling point in the UI influences the probability of that sampling point resulting in a correctly determined symbol value.

Consequently, the weight for a sampling point leading to a correctly decoded symbol will be the highest near the center of the UI. In contrast, the weight for a sampling point leading to an incorrectly decoded symbol will increase with the distance from the UI center.

In embodiments, respective intervals of a UI may be defined for the symbol error probability distribution. The symbol error probability distribution may be said to operate in such an embodiment in a discrete manner, and may output the same weight or probability for all data points within the respective interval.

In a further embodiment, which can be combined with all other embodiments mentioned above or below, the symbol error probability distribution may be determined based on signal parameters of the recorded analog waveform.

The specific embodiment of the symbol error probability distribution may be mathematically determined or determined via a mathematical estimation for the recorded analog waveform. The symbol error probability distribution may consequently be selected or at least parameterized based on specific signal parameters of the recorded analog waveform.

The symbol error probability distribution of function may be defined as an error probability p(err | t) that depends on the sampling time. A possible method to calculate it for each sampling time t may comprise the following steps:
1) Extract the column of the eye diagram at time t. The result of this is a set {x_m(t)} of M amplitude values, where M is the number of transmitted symbols.
2) Fit the extracted set of amplitude values to a model probability distribution function (e.g. a mixture of Gaussians with as many Gaussians as the PAM order N). The result of this is a set of parameters (e.g. the weights, means and variances of the N Gaussians. Each Gaussian represents the signal distribution conditioned on a particular transmitted symbol; its mean is the received symbol).
3) Use the model probability distribution function with the computed set of parameters to calculate the symbol error probability function. In the case of the mixture of Gaussians, the calculation is done as the weighted sum of the probabilities that each Gaussian realization is closer to the mean of another Gaussian than to its own mean.

Other signal parameters that may be used may e.g., comprise the III duration, the number of symbols that are present in the analog waveform, and the signal levels and/or amplitudes of the analog waveform.

In another embodiment, which can be combined with all other embodiments mentioned above or below, the symbol error probability distribution may be determined based on comparative measurements performed on the recorded analog waveform at different positions within one or multiple unit intervals.

In addition, or as alternative to mathematically determining the symbol error probability distribution, the symbol error probability distribution may also be determined experimentally.

To this end, it may be analyzed how often the same decoding result is provided by the decision feedback equalizer when performing the decision at another point of the respective UI as compared to the preferred decision point e.g., in the center of the UI, respectively. The relation between the number of different results and the overall number of results may then represent the weight or probability at the respective sampling point in the UI.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a flow diagram of an embodiment of a method according to the present disclosure;
Figure 2 shows a flow diagram of a possible embodiment of a step of the method according to the present disclosure;
Figure 3 shows a block diagram of an embodiment of a measurement application device controller according to the present disclosure;
Figure 4 shows a block diagram of an embodiment of a measurement application device according to the present disclosure;
Figure 5 shows a block diagram of an embodiment of a decision feedback equalizer for use with a measurement application device according to the present disclosure;
Figure 6 shows eye diagrams that may be generated with an embodiment of a measurement application device according to the present disclosure;
Figure 7 shows a block diagram of another embodiment of a decision feedback equalizer for use with a measurement application device according to the present disclosure;
Figure 8 shows eye diagrams that may be generated with an embodiment of a measurement application device according to the present disclosure;
Figure 9 shows a block diagram of an embodiment of another measurement application device according to the present disclosure; and
Figure 10 shows a block diagram of an embodiment of another measurement application device according to the present disclosure.

In the figures like reference signs denote like elements unless stated otherwise.

### DETAILED DESCRIPTION OF THE DRAWINGS

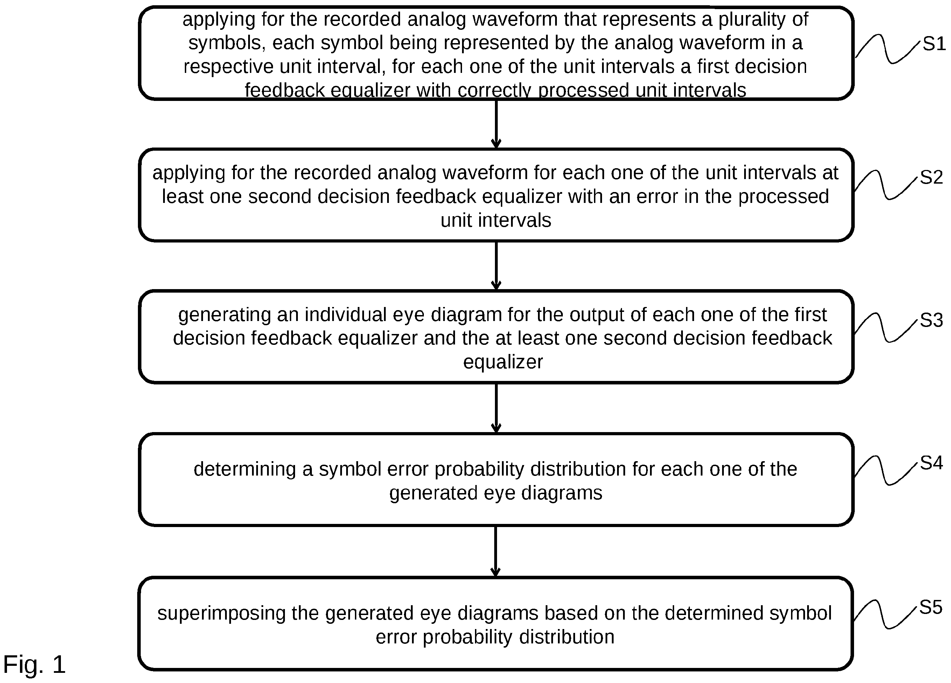

Figure 1 shows a flow diagram of a computer-implemented method for analyzing a recorded analog waveform 199, 299, 399, 499 that represents a plurality of symbols, each symbol being represented by the analog waveform in a respective unit interval.

The method comprises applying S1 for the recorded analog waveform 199, 299, 399, 499 for each one of the unit intervals a first decision feedback equalizer 102, 202, 319, 419 with correctly processed unit intervals, and applying S2 for the recorded analog waveform 199, 299, 399, 499 for each one of the unit intervals at least one second decision feedback equalizer 103-1 - 103-n, 203-1 - 203-n, 319, 419 with an error in the processed unit intervals. The method further comprises generating S3 an individual eye diagram 105, 205 for the output of each one of the first decision feedback equalizer 102, 202, 319, 419 and the at least one second decision feedback equalizer 103-1 - 103-n, 203-1 - 203-n, 319, 419, determining S4 a symbol error probability distribution for each one of the generated eye diagrams, and superimposing S5 the generated eye diagrams based on the determined symbol error probability distribution. The explanations provided herein for any other embodiment of the method apply to the method of figure 1 mutatis mutandis.

In the method the symbol error probability distribution may represent the probability of a data point of an eye diagram being output by the first decision feedback equalizer 102, 202, 319, 419 when provided with the recorded analog waveform 199, 299, 399, 499, especially for a specific sampling point in the respective UI. The symbol error probability distribution may comprises probabilities that are determined based on sampling points in the respective unit intervals, and a predetermined error pattern for the error in the decoded unit intervals.

The symbol error probability distribution may exemplarily be determined based on signal parameters of the recorded analog waveform 199, 299, 399, 499. In addition, e.g., as comparative, or alternatively, the symbol error probability distribution may be determined based on comparative measurements performed on the recorded analog waveform 199, 299, 399, 499 at different positions within one or multiple unit intervals.

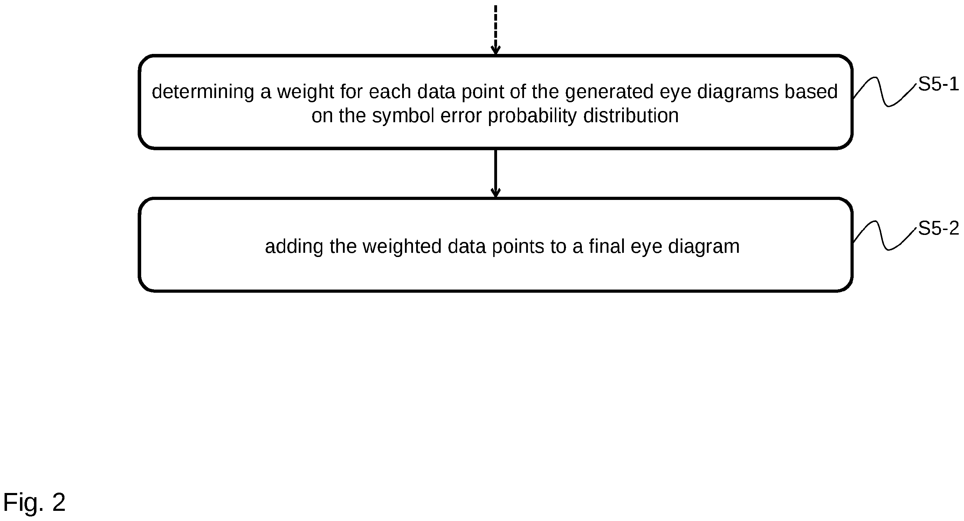

Figure 2 shows a detailed flow diagram of step S5 of superimposing of the method of figure 1. Step S5 of superimposing according to the embodiment of figure 2 may comprise determining S5-1 a weight for each data point of the generated eye diagrams based on the symbol error probability distribution, and adding S5-2 the weighted data points to a final eye diagram 108, 208.

The explanations provided herein for any other embodiment of the method apply to the method of figure 2 mutatis mutandis.

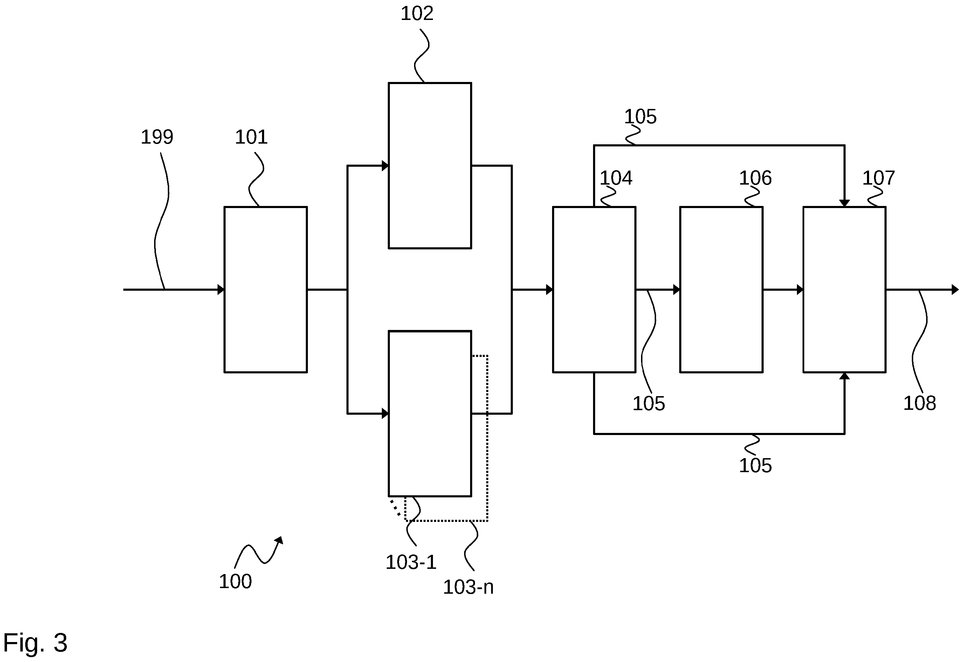

Figure 3 shows a measurement application device controller 100. The measurement application device controller 100 serves for analyzing a recorded analog waveform 199 that represents a plurality of symbols, each symbol being represented by the analog waveform in a respective unit interval. The measurement application device controller 100 comprises a data interface 101 that is coupled to a first decision feedback equalizer 102, and to least one second decision feedback equalizer 103-1 - 103-n. The first decision feedback equalizer 102, and the least one second decision feedback equalizer 103-1 - 103-n are both coupled to an eye diagram creator 104 that is coupled to a probability determiner 106. The eye diagram creator 104, and the probability determiner 106 are coupled to adder 107.

The data interface 101 receives the recorded analog waveform 199, and provides the recorded analog waveform 199 to the first decision feedback equalizer 102, and the at least one second decision feedback equalizer 103-1 - 103-n. The first decision feedback equalizer 102 equalizes each one of the unit intervals of the recorded analog waveform 199, e.g., determines a symbol value for the UI, based on correctly decoded unit intervals or the assumption of correct symbol values for the single taps of the equalizer. The at least one second decision feedback equalizer 103-1 - 103-n equalizes each one of the unit intervals, e.g., determines a symbol value for the UI, based on erroneously decoded unit intervals.

The eye diagram creator 104 generates an individual eye diagram 105 for the output of each one of the first decision feedback equalizer 102 and the at least one second decision feedback equalizer 103-1 - 103-n.

Further, the probability determiner 106 determines a symbol error probability distribution for each one of the generated eye diagrams. Finally, the adder 107, also called e.g., combiner, superimposes the generated eye diagrams based on the determined symbol error probability distribution to generate the final eye diagram 108.

For superimposing, the adder 107 may be configured to determine a weight for each data point of the generated eye diagrams based on the symbol error probability distribution, and add or superimpose the weighted data points to a final eye diagram 108. The weight, also called probability in this context, of each data point may determine the intensity or color of the respective data point in the final eye diagram 108.

The symbol error probability distribution may in the context of the present disclosure represent the probability of a data point of an eye diagram being output by the first decision feedback equalizer 102 when provided with the recorded analog waveform 199. As explained above, multiple additional eye diagrams are generated based on the output of the least one second decision feedback equalizer 103-1 - 103-n. For each one of these additional eye diagrams, the probability determiner 106 may determine the symbol error probability distribution for each data point. The symbol error probability distribution may comprise weights that are determined based on sampling points in the respective unit intervals, and a predetermined error pattern for the erroneously decoded unit intervals. The error pattern refers to erroneously decoded symbols that are provided to the respective decision feedback equalizer, and are thus used in respective taps of the feedback loop of the respective decision feedback equalizer, leading to an offset that is different than for correctly decoded unit intervals.

The single sampling points in this respect may be the data points of the respective eye diagram. Alternatively, intervals may be defined, wherein a sampling point may be in the center of each interval. The probability determined for such an interval may be applied to all data points within the respective interval. Using intervals instead of single data points may reduce the computational effort.

The probability determiner 106 may further determine the symbol error probability distribution based on signal parameters of the recorded analog waveform 199, like the signal type of the signal provided in the recorded analog waveform 199, the signal frequency of the recorded analog waveform 199, and the signal amplitudes or characterizing signal levels of the signal provided in the recorded analog waveform 199.

The probability determiner 106 may in embodiments determine the symbol error probability distribution based on comparative measurements performed on the recorded analog waveform 199 at different positions within one or multiple unit intervals.

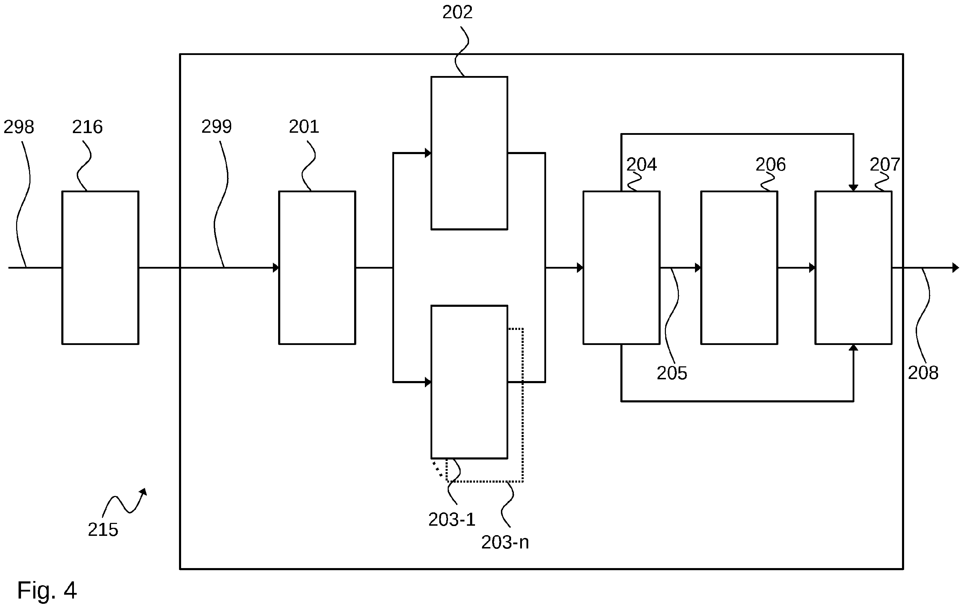

Figure 4 shows a measurement application device 215. The measurement application device 215 comprises a measurement interface 216 that is coupled to a measurement application device controller 200. The measurement application device controller 200 is based on the measurement application device controller 100 of figure 3. In other embodiments of the measurement application device 215, any embodiment of the measurement application device controller disclosed herein may be used.

As explained in more detail below, the measurement application device 215 may, e.g., comprise an oscilloscope or any other adequate measurement application device.

In embodiments, the measurement application device controller 200, or at least part of the functions of the measurement application device controller 200, may be implemented in as computer readable instructions that may be executed by a processing element or processor of the measurement application device 215. To this end, the computer readable instructions may be stored in a memory that may be coupled to the processing element or processor.

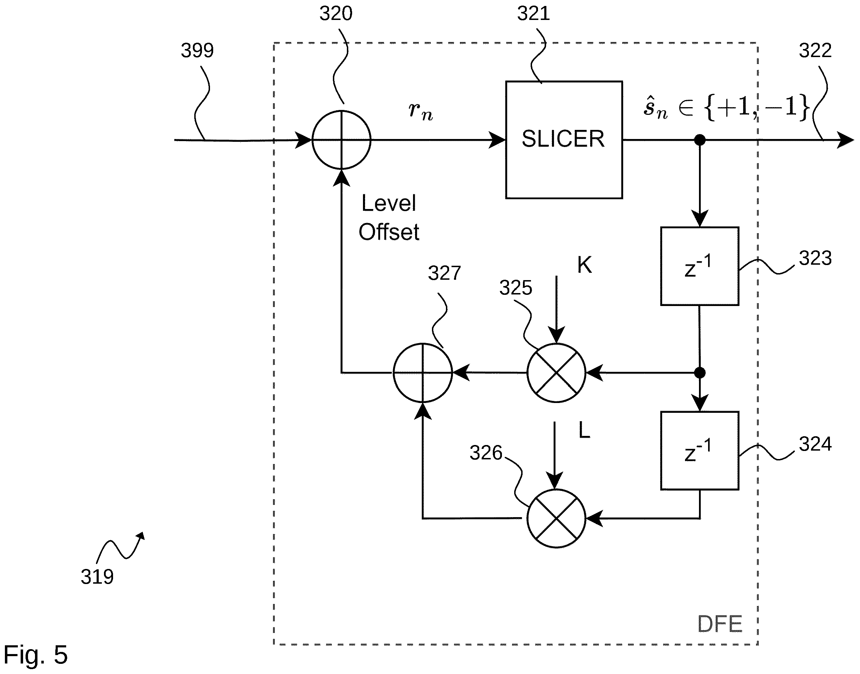

Figure 5 shows a decision feedback equalizer 319 for use with any one of the embodiments of the measurement application device according to the present disclosure. The decision feedback equalizer 319 is configured as 2-tap decision feedback equalizer 319 for a NRZ (non-return to zero), also called PAM-2 signal.

The decision feedback equalizer 319 comprises a summation block 320 that receives the recorded analog waveform 399. The output of the summation block 320 is provided to a slicer 321. The output of the slicer 321 is the output of the decision feedback equalizer 319. Further, the output of the slicer 321 is provided to a first unit delay block 323. The output of the first unit delay block 323 is provided to a first multiplier block 325, and to a second unit delay block 324. The output of the second unit delay block 324 is provided to a second multiplier block 326. The first multiplier block 325 multiplies the output of the first unit delay block 323 with a first constant K, and the second multiplier block 326 multiplies the output of the second unit delay block 324 with a second constant L. The outputs of the first multiplier block 325, and the second multiplier block 326 are both coupled to a summation block 327. The output of the summation block 327 is coupled to a second input of the summation block 320.

The slicer 321 outputs the symbol that is transmitted by the recorded analog waveform 399 in the currently processed UI. In the case of the PAM-2 signal, the slicer 321 may output a +1 or -1 for the respective UI,

For the shown arrangement, different values may be stored in the first unit delay block 323, and the second unit delay block 324, depending on the previously decoded Uls.

The following table shows the relation between the actual previous symbols, the (correctly or incorrectly) decoded previous symbols, and the resulting eye offset together with the respective symbol error probability distribution.

| Actual previous symbols | Decoded previous symbols | Eye offset | Probability distribution |
|---|---|---|---|
| -1, -1 | -1, -1 | 0 | P0 |
| -1, +1 | -1, +1 | 0 | P1 |
| +1, -1 | +1, -1 | 0 | P2 |
| +1, +1 | +1, +1 | 0 | P3 |
| -1, -1 | -1, +1 | 2K | P4 |
| -1, +1 | -1, -1 | -2K | P5 |
| +1, -1 | +1, +1 | 2K | P6 |
| +1, +1 | +1, -1 | -2K | P7 |
| -1, -1 | +1, -1 | 2L | P8 |
| -1, +1 | +1, +1 | 2L | P9 |
| +1, -1 | -1, -1 | -2L | P10 |
| +1, +1 | -1, +1 | -2L | P11 |
| -1, -1 | +1, +1 | 2L + 2K | P12 |
| -1, +1 | +1, -1 | 2L - 2K | P13 |
| +1, -1 | -1, +1 | -2L + 2K | P14 |
| +1, +1 | -1, -1 | -2L - 2K | P15 |

In the first column, the table shows the two previously transmitted symbols, that where actually transmitted prior to the current UI. In the second column, the table shows the two symbols, that were detected by the slicer 321, and that are stored in the first unit delay block 323, and the second unit delay block 324 for the current UI.

In the third column, the table shows the eye offset that results from the previously transmitted symbols, and the two symbols, that where detected by the slicer 321. As can be seen, if the two previously transmitted symbols, and the two symbols, that where detected by the slicer 321, are identical, no offset or an offset of 0 is present.

The probability distribution refers to the symbol error probability distribution function for the respective eye diagram. Such a symbol error probability distribution function may be calculated es explained above. Generally, the method allows computation of partial error probabilities (conditioned on particular symbols being sent and decoded). If the DFE has more than one tap, the error probability function for each previous symbol is computed with that method and then the results are multiplied together.

The explanations provided herein for any embodiment of the decision feedback equalizer apply mutatis mutandis to decision feedback equalizer 319.

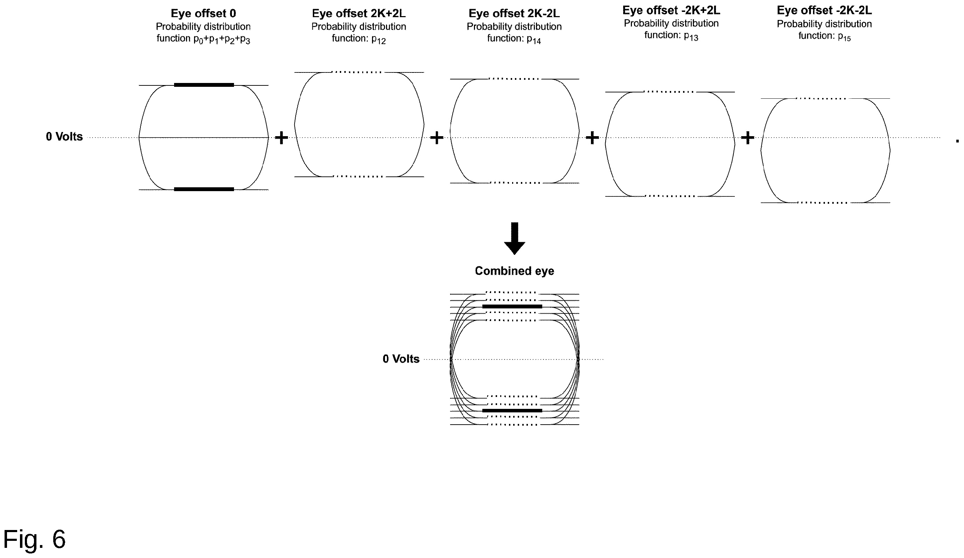

Figure 6 shows eye diagrams that may be generated with the measurement application device according to the present disclosure using the decision feedback equalizer 319 of figure 5 for a PAM-2 signal. Figure 6, below the single eye diagrams also shows the final or combined eye diagram.

In figure 6, the individual eye diagrams for offsets 0, 2K+2L, 2K-2L, -2K+2L, and -2K-2L are shown. The further eye diagrams for the further offsets are hinted at by three dots. In the eye diagrams, fully drawn lines refer to a relatively high probability, weight or intensity, while solid non-bold lines correspond to a lower probability, weight or intensity, and dotted lines correspond to an even lower probability, weight or intensity.

It can be seen, that the eye diagram for a correct decoding i.e., for offset 0, has higher weights in the horizontal sections of the lines of the eye diagram that occupy the center section of the UI shown in the eye diagram. In contrast, the eye diagrams referring to offsets other than 0, have a lower weight or probability in those sections, while at the same time showing a standard probability on the edges of the UI.

It can be seen that in the combined or final eye diagram, the superimposed individual eye diagrams lead to two horizontal sections with a high probability or weight, and almost no data points in these sections with an offset. In contrast, at the edges of the depicted UI, every single one of the individual Uls provides more or less the same weights or probabilities, but with the respective offset.

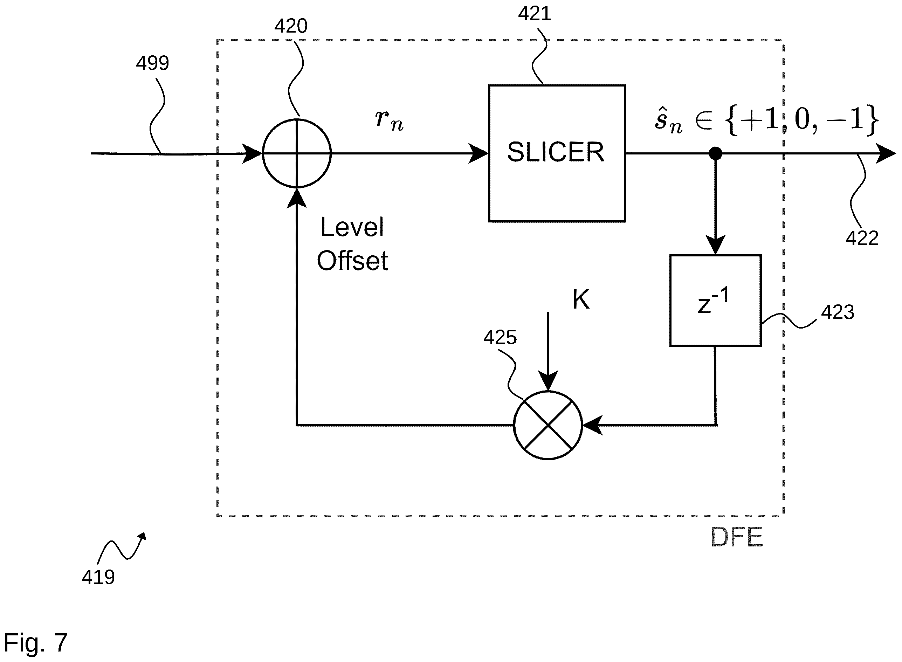

Figure 7 shows another decision feedback equalizer 419 for use with any one of the embodiments of the measurement application device according to the present disclosure. The decision feedback equalizer 419 is configured as 1-tap decision feedback equalizer 419 for a PAM-3 signal. The decision feedback equalizer 419 is based on the decision feedback equalizer 319. Consequently, the decision feedback equalizer 419 comprises a summation block 420 that receives the recorded analog waveform 499. The output of the summation block 420 is provided to a slicer 421. The output of the slicer 421 is the output of the decision feedback equalizer 419. Further, the output of the slicer 421 is provided to a unit delay block 423. The output of the unit delay block 423 is provided to a multiplier block 425. The multiplier block 425 multiplies the output of the first unit delay block 423 with a first constant K. The output of the multiplier block 425 is coupled to a second input of the summation block 420.

The slicer 421 outputs the symbol that is transmitted by the recorded analog waveform 499 in the currently processed UI. In the case of the PAM-3 signal, the slicer 421 may output a +1, 0 or -1 for the respective III.

For the shown arrangement, different values may be stored in the unit delay block 423, depending on the previously decoded III.

The following table shows the relation between the actual previous symbol, the (correctly or incorrectly) decoded previous symbol, and the resulting eye offset together with the respective symbol error probability distribution.

| Actual previous symbol | Decoded previous symbol | Eye offset | Probability distribution |
|---|---|---|---|
| -1 | -1 | 0 | P0 |
| 0 | 0 | 0 | P1 |
| +1 | +1 | 0 | P2 |
| -1 | +1 | 2K | P3 |
| -1 | 0 | K | P4 |
| 0 | +1 | K | P5 |
| +1 | 0 | -K | P6 |
| 0 | -1 | -K | P7 |
| +1 | -1 | -2K | P8 |

In the first column, the table shows the previously transmitted symbol, that was actually transmitted prior to the current UI. In the second column, the table shows the symbol, that was detected by the slicer 421, and that is stored in the first delay block 423 for the current UI.

In the third column, the table shows the eye offset that results from the previously transmitted symbol, and the symbol, that was detected by the slicer 421. As can be seen, if the previously transmitted symbol, and the symbol, that was detected by the slicer 421, are identical, no offset or an offset of 0 is present.

The probability distribution refers to the symbol error probability distribution for the respective eye diagram.

The explanations provided herein for any embodiment of the decision feedback equalizer apply mutatis mutandis to decision feedback equalizer 419.

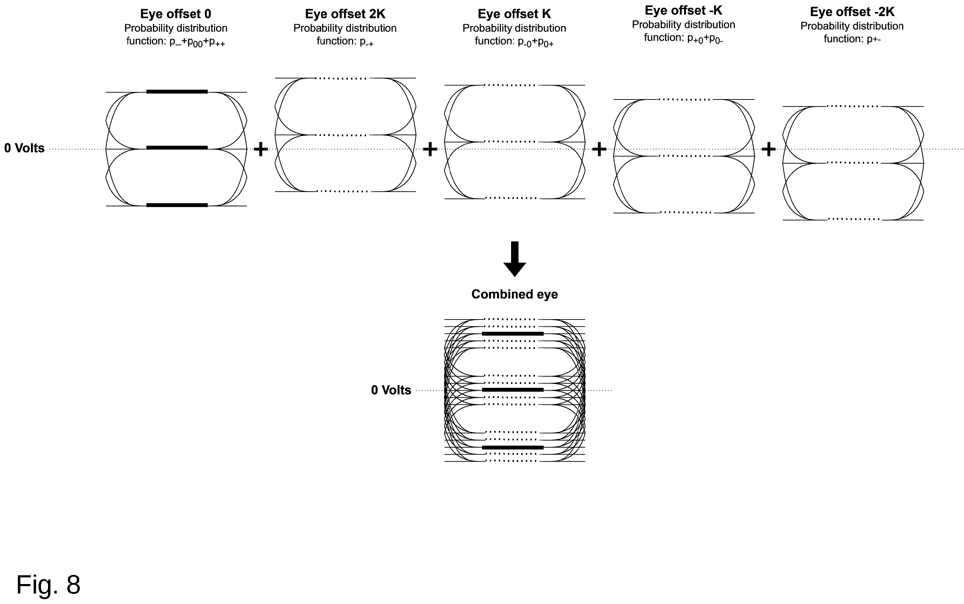

Figure 8 shows eye diagrams that may be generated with the measurement application device according to the present disclosure using the decision feedback equalizer 419 of figure 7 for a PAM-3 signal. Figure 7, below the single eye diagrams also shows the final or combined eye diagram.

In figure 7, the individual eye diagrams for offsets 0, 2K, K, -K, and -2K are shown. In the eye diagrams, fully drawn lines refer to a relatively high probability, weight or intensity, while solid non-bold lines correspond to a lower probability, weight or intensity, and dotted lines correspond to an even lower probability, weight or intensity.

It can be seen, that the eye diagram for a correct decoding i.e., for offset 0, has higher weights in the horizontal sections of the lines of the eye diagram that occupy the center section of the UI shown in the eye diagram. In contrast, the eye diagrams referring to offsets other than 0, have a lower weight or probability in that sections, while at the same time showing a standard probability on the edges of the UI.

It can be seen that in the combined or final eye diagram, the superimposed individual eye diagrams lead to three horizontal sections representing symbol values -1, 0, and 1 with a high probability or weight, and almost no data points in these sections with an offset. In contrast, at the edges of the depicted UI, every single one of the individual Uls provides more or less the same weights or probabilities, but with the respective offset.

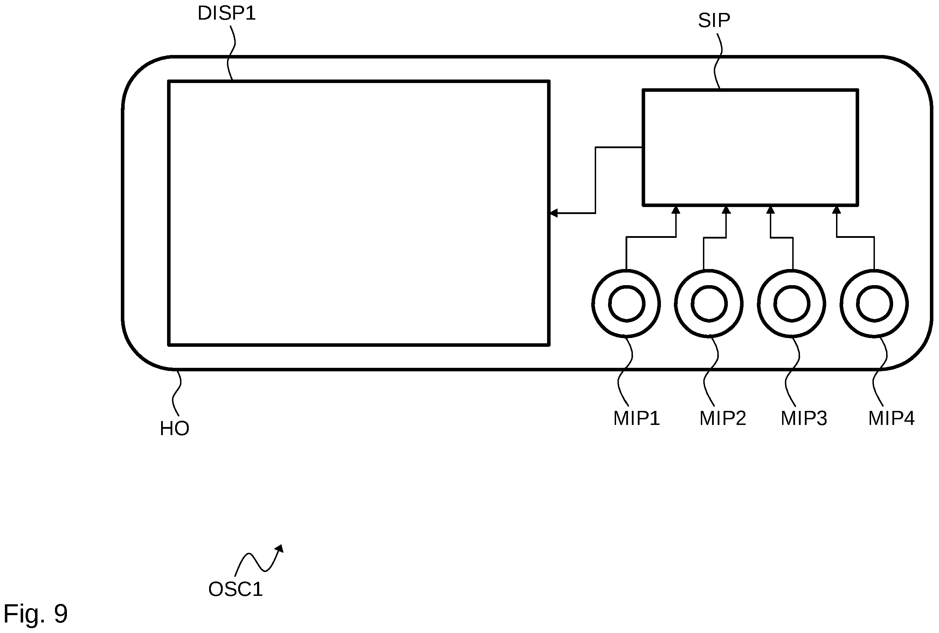

Figure 9 shows a block diagram of an oscilloscope OSC1 that may be used with an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

Although not explicitly shown, it is understood, that the oscilloscope OSC1 may also comprise signal outputs. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In the oscilloscope OSC1 the signal processor SIP or an additional processing element may perform the function of a measurement application device controller according to the present disclosure, or may implement the measurement application device controller. Of course, a communication interface may be provided in the oscilloscope OSC1 for communication with other measurement application devices.

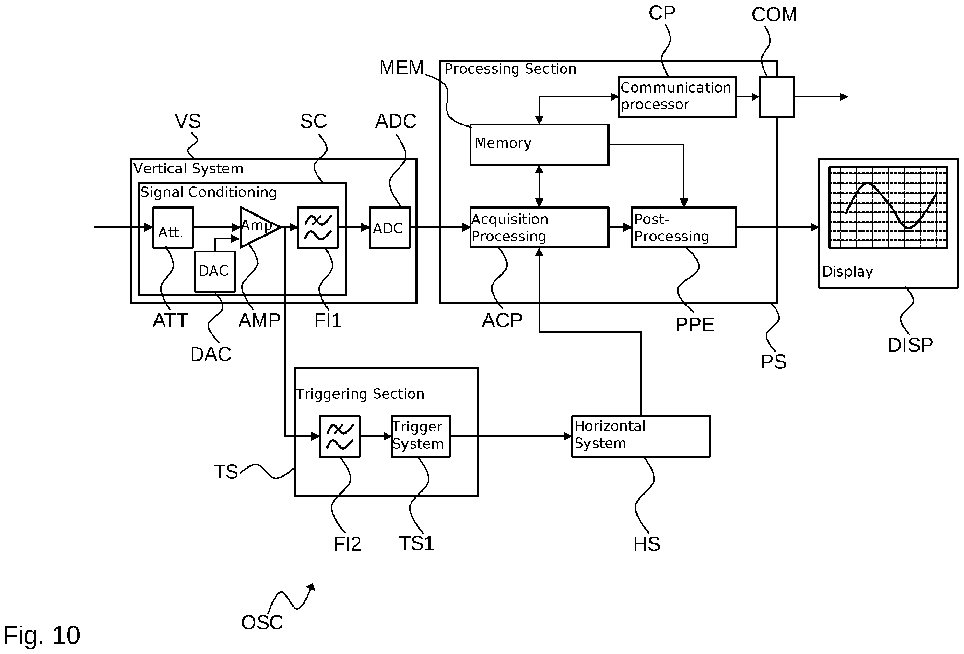

Figure 10 shows a block diagram of an oscilloscope OSC that may be an implementation of a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS and the display DISP. It is understood, that the partitioning into five general sections is a logical partitioning and does not limit the placement and implementation of any of the elements of the oscilloscope OSC in any way.

The vertical system VS mainly serves for offsetting, attenuating and amplifying a signal to be acquired. The signal may for example be modified to fit in the available space on the display DISP or to comprise a vertical size as configured by a user.

To this end, the vertical system VS comprises a signal conditioning section SC with an attenuatorATT and a digital-to-analog-converter DAC that are coupled to an amplifier AMP. The amplifier AMP is coupled to a filter FI1, which in the shown example is provided as a low pass filter. The vertical system VS also comprises an analog-to-digital converter ADC that receives the output from the filter FI1 and converts the received analog signal into a digital signal.

The attenuatorATT and the amplifier AMP serve to scale the amplitude of the signal to be acquired to match the operation range of the analog-to-digital converter ADC. The digital-to-analog-converter DAC serves to modify the DC component of the input signal to be acquired to match the operation range of the analog-to-digital converter ADC. The filter FI1 serves to filter out unwanted high frequency components of the signal to be acquired.

The triggering section TS operates on the signal as provided by the amplifier AMP. The triggering section TS comprises a filter FI2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be provided for the analog-to-digital converter ADC and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the amplifier AMP but will operate on the digital signal as provided by the analog-to-digital converter ADC.

A digital triggering section may comprise a processing element, like a processor, a DSP, a CPLD, an ASIC or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC and the output of the horizontal system HS as well as to a memory MEM and a post processing element PPE.

The acquisition processing element ACP manages the acquisition of digital data from the analog-to-digital converter ADC and the storage of the data in the memory MEM. The acquisition processing element ACP may for example comprise a processing element with a digital interface to the analog-to-digital converter ADC2 and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infra-red communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

In the oscilloscope OSC, any one of the processing elements in the processing section PS or an additional processing element may perform the function of the measurement application device controller according to the present disclosure.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### LIST OF REFERENCE SIGNS

- S1 - S5, S5-1, S5-2: method steps

- 100, 200: measurement application device controller
- 101, 201: data interface
- 102, 202: first decision feedback equalizer
- 103-1 - 103-n, 203-1 - 203-n: second decision feedback equalizer
- 104, 204: eye diagram creator
- 105, 205: individual eye diagram
- 106, 206: probability determiner
- 107, 207: adder
- 108, 208: final eye diagram

- 215: measurement application device
- 216: measurement interface

- 319, 419: decision feedback equalizer
- 320, 420: summation block
- 321, 421: slicer
- 322, 422: symbol value
- 323, 324, 423: unit delay block
- 325, 326, 425: multiplier block
- 327: summation block

- 199, 299, 399, 499: recorded analog waveform
- 298: analog waveform

- OSC1: oscilloscope
- HO: housing
- MIP1, MIP2, MIP3, MIP4: measurement input
- SIP: signal processing
- DISP1: display
- OSC: oscilloscope
- VS: vertical system
- SC: signal conditioning
- ATT: attenuator
- DAC1: analog-to-digital converter
- AMP: amplifier
- FI1: filter
- DAC: digital-to-analog converter
- ADC: analog-to-digital converter

- TS: triggering section
- AMP2: amplifier
- FI2: filter
- TS1: trigger system

- HS: horizontal system

- PS: processing section
- ACP: acquisition processing element
- MEM: memory
- PPE: post processing element

- DISP: display

## Claims

1. Computer implemented method for analyzing a recorded analog waveform (199, 299, 399, 499), the method comprising:
applying (S1) for the recorded analog waveform (199, 299, 399, 499) that represents a plurality of symbols, each symbol being represented by the analog waveform in a respective unit interval, for each one of the unit intervals a first decision feedback equalizer (102, 202, 319, 419) with correctly processed unit intervals;
applying (S2) for the recorded analog waveform (199, 299, 399, 499) for each one of the unit intervals at least one second decision feedback equalizer (103-1 - 103-n, 203-1 - 203-n, 319, 419) with an error in the processed unit intervals;
generating (S3) an individual eye diagram (105, 205) for the output of each one of the first decision feedback equalizer (102, 202, 319, 419) and the at least one second decision feedback equalizer (103-1 - 103-n, 203-1 - 203-n, 319, 419);
determining (S4) a symbol error probability distribution for each one of the generated eye diagrams;
superimposing (S5) the generated eye diagrams based on the determined symbol error probability distribution.

2. Method according to claim 1, wherein superimposing (S5) comprises
determining (S5-1) a weight for each data point of the generated eye diagrams based on the symbol error probability distribution; and
adding (S5-2) the weighted data points to a final eye diagram (108, 208).

3. Method according to any one of the preceding claims, wherein the symbol error probability distribution represents the probability of a data point of an eye diagram being output by the first decision feedback equalizer (102, 202, 319, 419) when provided with the recorded analog waveform (199, 299, 399, 499).

4. Method according to any one of the preceding claims, wherein the symbol error probability distribution comprises probabilities that are determined based on sampling points in the respective unit intervals, and a predetermined error pattern for the error in the decoded unit intervals.

5. Method according to any one of the preceding claims, wherein the symbol error probability distribution is determined based on signal parameters of the recorded analog waveform (199, 299, 399, 499).

6. Method according to any one of the preceding claims, wherein the symbol error probability distribution is determined based on comparative measurements performed on the recorded analog waveform (199, 299, 399, 499) at different positions within one or multiple unit intervals.

7. Measurement application device controller (100, 200) for analyzing a recorded analog waveform (199, 299, 399, 499) that represents a plurality of symbols, each symbol being represented by the analog waveform in a respective unit interval, the measurement application device controller (100, 200) comprising:
a data interface (101, 201) configured to receive the recorded analog waveform (199, 299, 399, 499);
a first decision feedback equalizer (102, 202, 319, 419) coupled to the data interface (101, 201) and configured to equalize each one of the unit intervals based on correctly decoded unit intervals;
at least one second decision feedback equalizer (103-1 - 103-n, 203-1 - 203-n, 319, 419) coupled to the data interface (101, 201) and configured to equalize each one of the unit intervals based on erroneously decoded unit intervals;
an eye diagram creator (104, 204) coupled to the first decision feedback equalizer (102, 202, 319, 419) and the at least one second decision feedback equalizer (103-1 - 103-n, 203-1 - 203-n, 319, 419), wherein the eye diagram creator (104, 204) is configured to generate an individual eye diagram (105, 205) for the output of each one of the first decision feedback equalizer (102, 202, 319, 419) and the at least one second decision feedback equalizer (103-1 - 103-n, 203-1 - 203-n, 319, 419);
a probability determiner (106, 206) coupled to the eye diagram creator (104, 204) and configured to determine a symbol error probability distribution for each one of the generated eye diagrams; and
an adder (107, 207) coupled to the eye diagram creator (104, 204) and the probability determiner (106, 206), wherein the adder (107, 207) is configured to superimpose the generated eye diagrams based on the determined symbol error probability distribution.

8. Measurement application device controller (100, 200) according to claim 7,
wherein superimposing comprises determining a weight for each data point of the generated eye diagrams based on the symbol error probability distribution; and
adding the weighted data points to a final eye diagram (108, 208).

9. Measurement application device controller (100, 200) according to any one of the preceding claims 7-8, wherein the symbol error probability distribution represents the probability of a data point of an eye diagram being output by the first decision feedback equalizer (102, 202, 319, 419) when provided with the recorded analog waveform (199, 299, 399, 499).

10. Measurement application device controller (100, 200) according to any one of the preceding claims 7 to 9, wherein the probability determiner (106, 206) is configured to determine the symbol error probability distribution comprising weights that are determined based on sampling points in the respective unit intervals, and a predetermined error pattern for the erroneously decoded unit intervals.

11. Measurement application device controller (100, 200) according to any one of the preceding claims 7 to 10, wherein the probability determiner (106, 206) is configured to determine the symbol error probability distribution based on signal parameters of the recorded analog waveform (199, 299, 399, 499).

12. Measurement application device controller (100, 200) according to any one of the preceding claims 7 to 11, wherein the probability determiner (106, 206) is configured to determine the symbol error probability distribution based on comparative measurements performed on the recorded analog waveform (199, 299, 399, 499) at different positions within one or multiple unit intervals.

13. Measurement application device (215) comprising:
a measurement application device controller (100, 200) according to any one of claims 7 to 12; and
a measurement interface (216) coupled to the measurement application device controller (100, 200), wherein the measurement interface (216) is configured to measure an analog waveform and provide the measured analog waveform as digital data to the measurement application device controller (100, 200) .
